(19)

Europäisches
Patentamt
European
Patent Office
Office européen
des brevets

(11)     EP 2 524 974 B1

(12)     EUROPEAN PATENT SPECIFICATION

(45) Date of publication and mention
of the grant of the patent:
**07.05.2014   Bulletin 2014/19**

(51) Int Cl.:
***C23C 14/24*** *(2006.01)*

(21) Application number: **11305604.8**

(22) Date of filing: **18.05.2011**

(54) **Injector for a vacuum vapour deposition system**

Injektor für ein Vakuum-Dampfabscheidungssystem

Injecteur pour système de dépôt de vapeur sous vide

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.11.2012   Bulletin 2012/47**

(73) Proprietor: **Riber**
**95870 Bezons (FR)**

(72) Inventors:
• **Guyaux, Jean-Louis**
**91380 Chilly-Mazarin (FR)**

• **Stemmelen, Franck**
**95490 Vaureal (FR)**
• **De Oliveira, Christophe**
**78400 Chatou (FR)**

(74) Representative: **Chauvin, Vincent et al**
**Cabinet Harle et Phelip**
**14/16 rue Ballu**
**75009 Paris (FR)**

(56) References cited:
**WO-A1-2008/004792     KR-A- 20110 024 223
US-A1- 2010 248 416     US-A1- 2011 027 462**

## Description

## Technical Field

The present invention relates to an injector for a vacuum deposition system.

## Background

Known vacuum deposition systems are used for the manufacture of thin films structures over large size substrates or panels. For instance such systems are used for depositing CIGS (Copper Indium Gallium Selenium) solar cells or OLED (organic light-emitting device) diodes. Vacuum deposition systems generally comprise an evaporation source connected to a vacuum deposition chamber. The vacuum evaporation source evaporates or sublimates materials, which are transferred in gaseous form to the vacuum deposition chamber. In particular, such a vacuum evaporation source is used to evaporate selenium for glass substrate selenisation in horizontal top-down or bottom-up in line systems. The vacuum deposition chamber is suitable for receiving substrate(s) to be covered by vaporized materials thus making panel(s). Different chamber configurations enable deposition either on a single substrate or on a plurality of substrates positioned in the chamber. Substrates can be solid such as sheet of glass or fexible such as a metalic or a plastic film. When the substrate is flexible, such a vacuum deposition system is compatible with roll roll processes.

Known vacuum deposition systems also comprise an injector connected to the evaporation source and placed in front of the substrate. The injector enables to spray the vaporized materials through apertures or nozzles over a large surface. The geometry of the injector depends on the size and geometry of the substrate to be covered. For large area rectangular flat substrates, the injector comprises a longitudinally extending injector duct. The prior art injector comprises identical nozzles which are equidistant and aligned along the longitudinal axis. The length of the injector duct is at least as large as the length or width of a substrate.

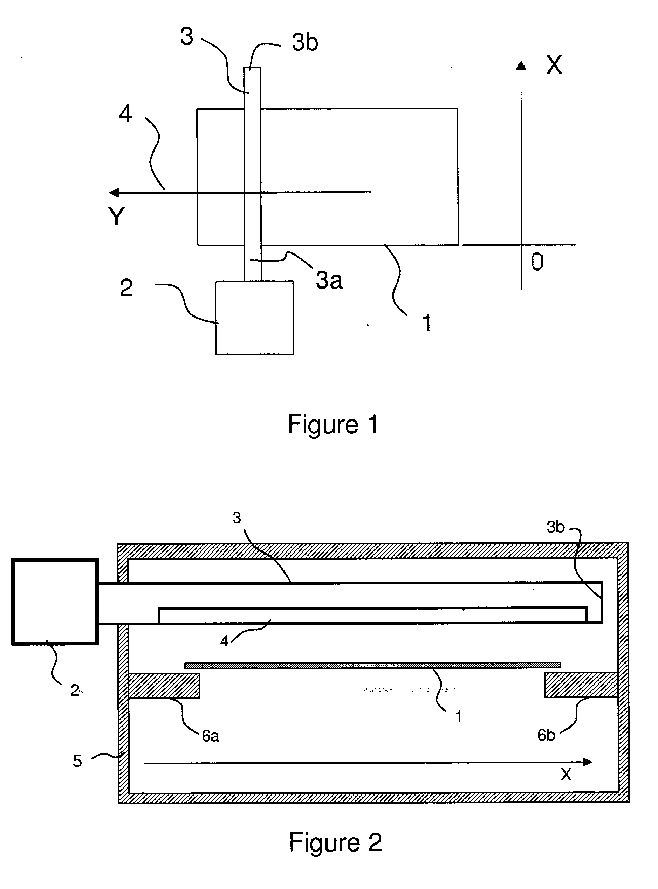

Figure 1 represents schematically a top view of a deposition system and a substrate (1). The deposition system comprises an evaporation source (2) connected to an injector (3). The vacuum deposition chamber is not represented. The longitudinal injector (3) is used in combination with a mechanical device for imparting a relative movement between the injector (3) and the substrate (1) in a direction (Y) transverse to the longitudinal axis (X) of the injector (3). During deposition, the substrate (1) or the injector (3) moves along direction (Y) which is perpendicular to the longitudinal axis (X) of the injector (3). This configuration enables deposition of vaporized materials over the whole substrate surface.

Figure 2 represents schematically a view along a longitudinal section of a deposition system as represented in figure 1. The deposition system comprises an evaporation source (2) connected to the duct of an injector (3) in a vacuum deposition chamber (5). The injector (3) comprises a diffuser (4) extending along its longitudinal axis. A substrate (1) to be covered by deposition materials is placed in the vacuum deposition chamber (5). In top-down configuration, the injector (3) is above a substrate (1) to be covered by a deposition layer, the distance between the injector (3) and the substrate (1) being around 50 mm. However, according to the material to be vaporized and the expected deposition throughput, the distance between the injector and the substrate can vary. The substrate (1) lies on rollers (6a, 6b) in a plane parallel to the longitudinal axis (X) of the injector (3). The longitudinal injector (3) receives vaporized materials from the source (2) through an input port (non represented) at one end of said injector. The diffuser (4) sprays said vaporized materials on the substrate (1) along the length of the diffuser.

Uniformity of deposition is of prime importance for thin film deposition process, such as fabrication of semiconductors, flat panel displays, organic light emission devices or solar cells. However, obtaining a high uniformity of deposition across the surface of a substrate remains difficult using prior art vacuum deposition systems, especially as substrate size tends to increase. Especially, uniformity of deposition along a longitudinal axis X parallel to the diffuser is difficult to obtain on account of several parameters which will be detailed below.

Besides, some vaporized materials are not deposited on the substrate but are diffused into the deposition chamber and are finally deposited on the walls of the chamber. Especially, it is believed that a large proportion of the material diffused at the extremities of the diffuser is lost. Diffusion of vaporized materials in prior art vacuum deposition systems thus leads to an important loss of materials. The average deposition throughput is currently limited to about 85%.

Also, vaporized materials such as selenium or sulphur used in vapour deposition systems are corrosive. The diffuser may be corroded by these materials. As a result of this corrosion, the nozzles' geometry is modified, which modifies the diffusion pattern over time. Thus, prior art diffusers also present a problem of repeatability of diffusion profiles over time.

Additionally, during the deposition process, a part of the vaporized materials decomposes on the internal walls of the nozzle. The decomposed materials may clog the exit aperture of a nozzle. Clogging of a single nozzle aperture in a vacuum vapour deposition machine can impair uniformity in thickness and/or composition of the material deposited on a substrate. In that case, cleaning of the nozzle is required.

Besides, a same deposition machine might be used for different types of applications, or different substrates with varying dimensions. Depending on the applications, it is sometimes required to replace the diffuser with another diffuser having an optimized number of nozzle exit aperture, optimized nozzle positions, geometry and/or throughput.

The diffuser cleaning or exchange operations usually require turning down the vacuum vapour deposition machine. However, downtime of each processing step turns into increased fabrication costs. Therefore, the downtime of each processing tool is closely controlled and must be kept to a minimum.

Document US 2010/0248416 discloses an injector for a vacuum deposition system, said injector comprising removable nozzle inserts for replacement and/or interchangeability of nozzle inserts.

## Technical Problem

One of the objectives of the invention is to improve uniformity of deposition of vaporized materials, in particular along the axis of the injector. The uniformity of the deposition is defined relatively to the thickness of the deposited layer that varies between a highest maximum value $Th_{max}$ and a lowest minimum value $Th_{min}$ as proportional to :

$$\frac{Th_{max} - Th_{min}}{Th_{max} + Th_{min}}$$

This uniformity has to be the lowest possible.

Another objective of the invention is to increase the deposition throughput of a vapour deposition system.

Another objective of the invention is to improve the repeatability of the deposition process over time.

Another subsidiary objective of the invention is to reduce the downtime of a vacuum vapour deposition machine necessary for cleaning or replacing the diffuser.

Another subsidiary objective of the invention is to improve versatility of the diffuser of a vacuum vapour deposition machine for different applications.

## Summary of the invention

The present invention thus provides an injector for a vacuum vapour deposition system, said injector comprising an injection duct suitable for receiving vaporized materials from a vacuum evaporation source and a diffuser comprising a plurality of nozzles for diffusing said vaporized materials into a vacuum deposition chamber, each nozzle comprising a channel suitable for connecting said injection duct to said deposition chamber. According to the invention, said diffuser has a spatially varying nozzle distribution, at least one of said nozzles comprising at least one removable diffuser insert, said diffuser comprising diffuser insert receiving means and said diffuser insert comprising attachment means suitable for being fitted to said receiving means, and said diffuser comprises at least one diffuser insert suitable for obturating a nozzle.

According to various aspects of the invention spatially varying nozzle distribution signifies that:

- said diffuser comprises at least two nozzles having different channel geometries and/or
- said diffuser comprises at least three nozzles aligned **along a** longitudinal axis and having different spacings between two adjacent nozzles.

According to different aspects of the preferred embodiment of the invention :

- said diffuser insert comprises at least an input aperture at one end of a channel emerging inside said injection duct and at least an output aperture at another end of said channel emerging outside said injection duct ;

- said diffuser receiving means comprise an internal thread and said diffuser insert attachment means comprise an external thread fitted to said diffuser internal thread ;

- said diffuser receiving means comprise an external thread and said diffuser insert attachment means comprise an internal thread fitted to said diffuser external thread.

The invention also concerns a vacuum deposition system comprising a vacuum evaporation source, an injector and a vacuum deposition chamber, said injector comprising an injection duct suitable for receiving vaporized materials from the vacuum evaporation source and a diffuser comprising a plurality of nozzles for diffusing said vaporized materials into the vacuum deposition chamber, each nozzle comprising a channel suitable for connecting said injection duct to said deposition chamber, wherein said diffuser has a spatially varying nozzle distribution.

The invention also concerns a process for calibrating an injector, comprising the following steps :

(a) arrangement of a diffuser comprising a plurality of nozzles distributed along a longitudinal axis following an initial configuration wherein at least one of said nozzles comprises at least one removable diffuser insert and wherein at least one removable diffuser insert is suitable for obturating a nozzle ;

(b) deposition of vaporized materials on a substrate using said diffuser in said initial configuration ;

(c) measurement of a uniformity profile of said deposited materials ;

(d) modification of the spatial distribution of said nozzles as a function of said measured uniformity profile, in order to reduce non-uniformity of deposited materials.

Said process can comprise repeated implementation of steps (b) to (d) until the uniformity profile is satisfying. Advantageously, repetition of steps (b) to (d) is implemented until a predetermined uniformity of $\pm$ 7% or better is obtained.

Modification of the spatial distribution of said nozzles includes:

- modification of the geometry of at least one nozzle channel,

  or

- modification of the pitch between two channels.

According to a favourite variant, modification of the spatial distribution of said nozzles comprises a replacement of the removable diffuser insert by another removable diffuser insert.

Advantageously, according to a preferred embodiment of the process of the invention, each of said nozzles comprises one removable diffuser insert as has been disclosed above, so that the modification of the spatial distribution of said nozzles is facilitated and can consist simply in a replacement of the removable diffuser inserts by other removable diffuser inserts.

The invention also concerns a process for manufacturing a diffuser for an injector for a vacuum deposition system, comprising the following steps :

(e) manufacturing of an injector for a vacuum deposition system, said injector comprising a diffuser comprising at least a plurality of diffuser insert receiving means aligned along a longitudinal axis,

(f) manufacturing of a removable diffuser insert comprising attachment means suitable for being fitted to to said receiving means of said diffuser, wherein at least one removable diffuser insert is suitable for obturating a nozzle

(g) assembling said removable diffuser insert with said diffuser.

Still another aspect of the invention concerns a process for manufacturing a diffuser for an injector for a vacuum deposition system, said process comprising the following steps :

(h) Providing an injector comprising a diffuser comprising an injection duct and at least a plurality of diffuser insert receiving means aligned along a longitudinal axis;
(i) Modelling the diffusion profile of a diffuser insert using diffusion flow models;
(j) Correcting the diffusion profile of a set of a plurality of inserts as a function of the respective positions of each insert along the longitudinal axis of said diffuser;

(k) Comparing the desired diffusion profile with the modelled diffusion profile of the set of diffuser inserts;
(l) Defining the diffuser insert distribution corresponding to the desired diffusion profile;
(m) Inserting diffuser inserts comprising attachment means suitable for being fitted to said receiving means of said diffuser into the corresponding receiving means wherein at least one removable diffuser insert is suitable for obturating a nozzle.

The invention applies in particular to vacuum vapour deposition systems for implementing the selenation step of CIGS type solar cells.

The present invention concerns also the features disclosed in the following description and which are to be considered alone or according to any feasible technical combination.

**Brief description of the drawings**

This description is given for non limiting illustrative purpose only and will better be understood when referring to the annexed drawings wherein:

- Figure 1 represents schematically a top view of a deposition system and a substrate to be covered by vaporized materials;
- Figure 2 represents schematically a side view of the deposition system of figure 1 along a longitudinal section;
- Figure 3 represents measurements of a deposited layer thickness as a function of position on the substrate along the longitudinal axis of the injector;
- Figure 4 represents schematically a bottom view of a deposition system and a substrate to be covered;
- Figure 5 represents schematically different nozzles having different channel geometries;
- Figure 6 represents schematically a diffuser insert attached to a diffuser according to an embodiment of the invention;
- Figure 7 represents a configuration of inserts positions with respect to a substrate to be covered, according to an embodiment of the invention;
- Figure 8 represents schematically a partial cut-view of an injector, according to an embodiment of the invention;
- Figure 9 represents a perspective view of a removable diffuser insert, according to an embodiment of the invention.

**Detailed description**

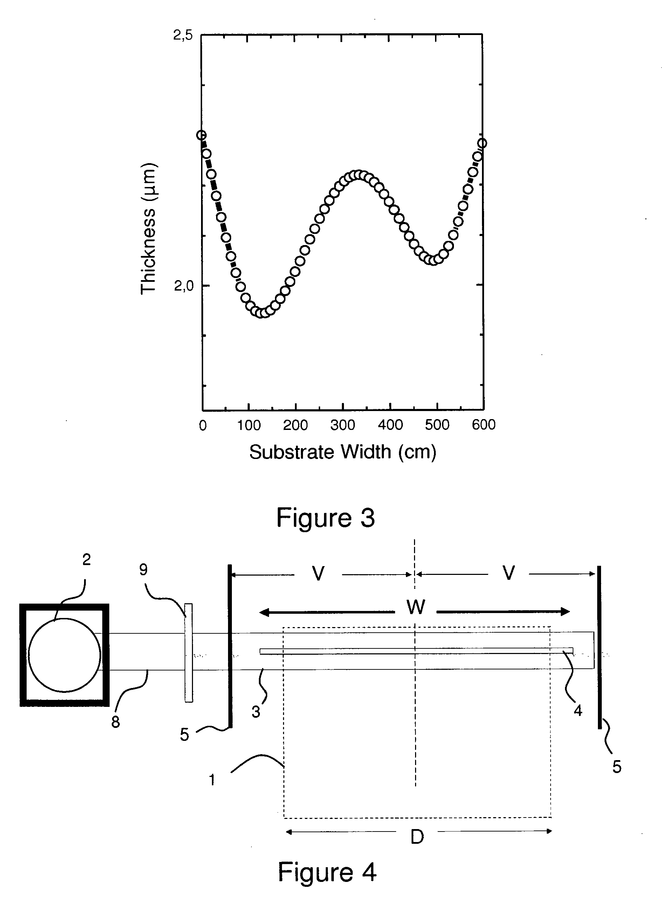

Figure 3 represents a uniformity profile of a deposited layer obtained by a prior art vacuum deposition system such as represented on figures 1 and 2. More precisely, the uniformity profile of figure 3 is obtained by measuring the thickness of a selenium layer as a function of the position on a glass substrate (1) along the longitudinal axis X of the injector (3). The overall dimensions of the glass substrate (1) are 60x40 cm. The position X = 0 corresponds to the border of the substrate facing the input port (3a) of the injector (3). The position X = 60 cm corresponds to the border of the substrate facing the opposite end (3b) of the injector (3). Several observations derive from the uniformity profile of figure 3. First, the thickness of deposited selenium is similar (around 2,3 $\mu$m) at the borders of the substrate, *i.e.* at positions X= 0 and X= 60 cm respectively. However, the deposition is clearly non uniform across the substrate. The profile shows a local peak thickness at the centre of the substrate (X-30 cm) and two local minima on the sides. Moreover, the profile is not symmetric with respect to an axis Y passing through the centre of the substrate. Non uniformity measures the statistical difference between minimum, maximum and average thickness. Non uniformity in thickness amounts to about $\pm 8.9\%$ on Figure 3.

Figure 4 represents schematically a top view of a deposition system and a substrate (1), according to an embodiment of the invention. The evaporation source (2) is connected to the injector (3) via a connecting tube (8) and a connecting flange (9). The injector (3) comprises a diffuser (4) extending along its longitudinal axis. A substrate (1) to be covered by deposition materials is placed in the vacuum deposition chamber (5). The vacuum deposition chamber has a width 2*V. The diffuser (4) has a length W. The substrate (1) has a width D. The diffuser length W is slightly larger than the substrate width D. The width 2*V of the vacuum deposition chamber is larger than the length W of diffuser (4). In some configurations, several substrates can be placed side by side in the vacuum deposition chamber for increasing throughput. For instance, two substrates having a width of D/2 can be placed next to each other in the same deposition chamber, for receiving simultaneously vaporized deposition materials from a single diffuser (4).

A vacuum deposition system is represented on figure 4. The source (2) vaporizes or sublimates materials above temperature of evaporation or sublimation for said materials. The temperature of selenium is around 350 °C. The injector (3) is heated in order to prevent vaporized materials from condensing inside the injector. Possibily, the walls of the deposition chamber (5) are also heated. The substrate (1) thus receives thermal radiation from the injector (3) and from any other hot parts of the deposition chamber (5). However, the thermal radiation received by the substrate is not distributed uniformly across the surface of the substrate. This non uniform heating results in spatial variations in the substrate temperature. The non uniformity in substrate temperature can be measured. Measured temperatures on the substrate are generally not symmetric with respect to an axis Y passing through the centre of the deposition chamber and transverse to the longitudinal axis X. As a result, vaporized materials tend to condense on locations having relatively lower temperatures whereas materials deposited on higher temperature locations are more easily prone to re-diffusion or re-evaporation.

Another aspect is related to the geometry of the injector (3) as represented on figure 4. The injector duct receives vaporized materials from an input port at an end (3a) of its longitudinal axis. However, the flow of materials is not constant along the axis of the injector, due to a pressure drop from the input port (3a) to the opposite end (3b) of the injector (3).

In turn, the spatial variations of substrate temperature combined with the injector configuration lead to a non uniform deposition of vaporized materials on the substrate (1) along the longitudinal axis of the injector. The thickness profile measured on figure 3 thus probably results from combined effects of asymmetric injection and of substrate temperature non uniformity.

According to an aspect of the invention, the diffuser (4) comprises nozzles of different geometry and/or a spatially non uniform distribution of nozzles along the longitudinal axis of the injector, in order to decrease non uniformity of deposited materials thickness on the substrate. More precisely, the diffuser (4) comprises at least two nozzles having different channel geometries or at least three nozzles aligned along a longitudinal axis and having different spacings between two adjacent nozzles.

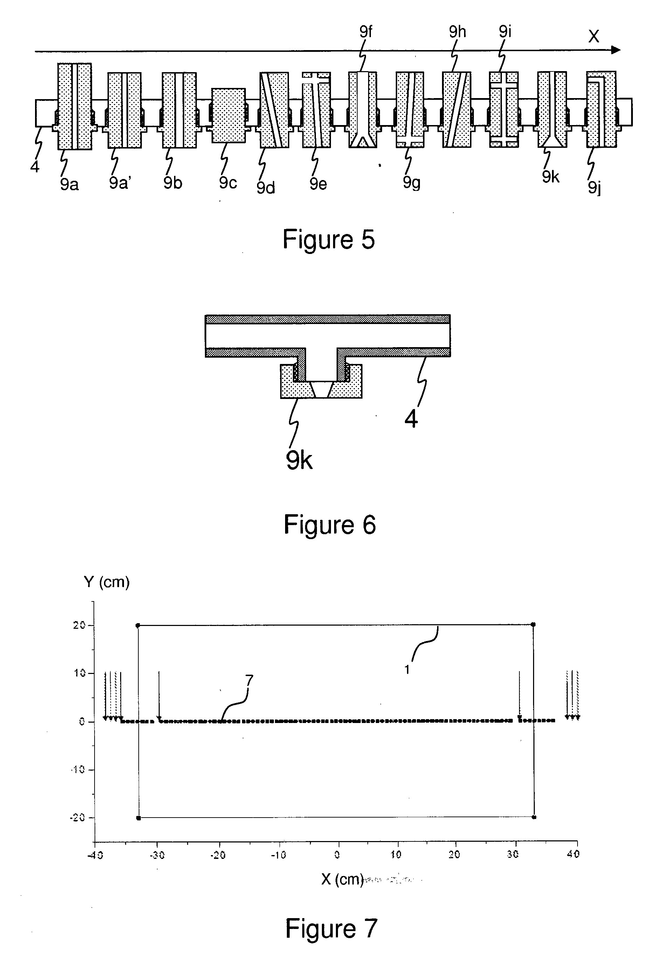

Figure 5 represents schematically a longitudinal cut-view of a diffuser (4) according to an embodiment of the invention. The shape of the injector (3) is a hollow cylinder with an annular cross section and a longitudinal axis X. The diffuser (4) can be machined on a side of the injector body. The diffuser (4) may also be a separate mechanical part, attached against an opening in the injector (3) body. The diffuser (4) comprises a plurality of nozzles (9a, 9b, ..., 9j) aligned along the longitudinal axis X. Each nozzle (9a, 9b, ..., 9j) generally comprises a channel (13), an input aperture (11) emerging inside the injection duct and an output aperture (12) emerging outside the injection duct. Prior art diffusers generally have a periodic distribution of identical nozzles along the longitudinal axis with a constant pitch between adjacent nozzles.

According to an embodiment of the invention, the different nozzles of the diffuser have different geometrical features. Figure 5 represents schematically different types of inserts which, when they are inserted into the diffuser receiving means constitute nozzles. For example insert and nozzle (9a) and insert and nozzle (9b) have a straight channel, one input aperture and one output aperture. However, the diameter of the channel of nozzle (9b) is larger than the diameter of the channel of nozzle (9a). Thus nozzle (9b) produces a higher diffusion flow than nozzle (9a). Different nozzles may have different output aperture sizes and/or different shapes of channel, input and/or output aperture. One insert and nozzle (9a) has a cylindrical channel with a circular cross section; another insert and nozzle (9k) may have a conical channel. A nozzle may comprise a bevelled input and/or output aperture. The diffuser (4) may comprise different nozzles having different channel lengths.

Another insert and nozzle (9f) comprises a channel connecting a single input aperture to a plurality of output apertures. Conversely, another nozzle may comprise a channel connecting a plurality of input apertures to a single output aperture. Another nozzle may comprise a plurality of channels, each channel connecting one or several apertures. According to an embodiment, an insert and nozzle (9i) comprises a cylindrical channel having a central axis perpendicular to the longitudinal axis X and said nozzle comprises a plurality of lateral output apertures. According to another embodiment different inserts and nozzles (9d, 9g) comprise channels with different channel axis angle with respect to the longitudinal axis. In a particular embodiment, the angle of the channel axis varies as a function of the nozzle position along the diffuser longitudinal axis. For instance, the nozzles (9d, 9e, 9g, and 9h) at both ends of the diffuser (4) may be tilted toward the centre of the deposition chamber.

The diffuser configuration with different nozzle geometries enables to modify the flow of vaporized materials through the diffuser in order to reduce non uniformity of deposited materials. This diffuser configuration enables to compensate for non uniformity in temperature and/or in flow of vaporized materials. The nozzle geometry and distribution also enables reducing losses of materials deposited on the walls (5) of the deposition chamber.

According to another aspect of the invention, the spacing between adjacent nozzles is not constant. To that end, the diffuser can be manufactured with predetermined spacing between nozzle positions. According to a preferred embodiment, the diffuser comprises equally spaced nozzle positions, but some nozzles are plugged. A particular insert (9c) with an end cap can be used for enabling local plugging of the nozzle. Figure 7 represents a top view of a substrate and a diffuser configuration. The diffuser comprises several tens of nozzles distributed along the diffuser length. Each nozzle is represented by a black square or disk corresponding to nozzles with two distinct nozzle geometries. The arrows represent individual end-capped nozzles which are plugged for modifying vaporised materials deposition near the borders of the substrate.

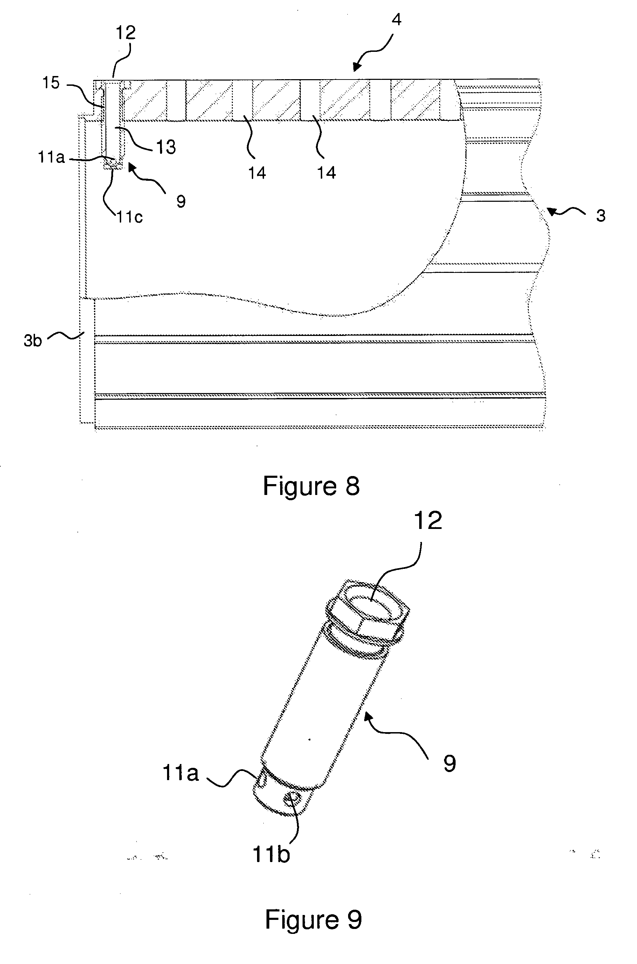

A preferred embodiment of the invention will now be described in reference to figures 8 and 9. Figure 8 represents schematically a partial cut-view of an injector (3) with a diffuser (4). The injector (3) comprises an injection duct that is a hollow cylinder with a circular cross section. The diffuser (4) comprises a plurality of through holes (14). Preferably, each hole (14) comprises a threaded part. According to this embodiment, the diffuser comprises removable diffuser inserts (9) into each hole (14). When the diffuser insert (9) is inserted into a hole (14), it makes a nozzle.

Figure 9 represents a perspective view of a removable diffuser insert (9) according to a preferred embodiment of the invention. The diffuser insert (9) has a generally cylindrical shape. The diffuser insert (9) comprises an inner channel (13) connecting a plurality of input apertures (11 a, 11 b, 11c) to an output aperture (12). The diffuser insert (9) comprises an external thread (15). The diffuser insert comprises a flanged-hex head for screwing said diffuser insert into the diffuser hole (14) using common wrenches. The insert (9) can thus be inserted and removed easily from the diffuser (4). A diffuser (4) with identical threaded holes (14) is suitable for receiving diffuser inserts having various geometric features as detailed above in reference to figure 5.

In case vaporized materials induce corrosion of a diffuser insert (9), said corroded diffuser insert is easily replaced with a new diffuser insert. Replacement of diffuser inserts (9) is less expensive than replacement of the whole diffuser (4) or injector (3).

A particular diffuser insert (9c) represented on figure 5 is provided with an end cap thus preventing diffusion of any vaporized materials. Such an end-capped insert functions as a plug for closing a diffuser hole (14). A plurality of such end-capped inserts can be plugged into several diffuser holes (14) while regular open channel diffuser inserts are inserted into the other diffuser holes. The spatial distribution of vaporized materials through the diffuser can thus be controlled closely. For instance, in the deposition system producing a deposition profile as represented on figure 3, end-capped inserts may be plugged at the centre and near both ends of the diffuser, in order to reduce the local peaks in deposited thickness. Such end-capped inserts can also be used to adjust the operational diffuser length to the actual size of the substrates. This enables manufacturing of a standard diffuser and customization of said diffuser for each application.

According to an alternative diffuser insert embodiment, represented on Figure 6, a diffuser (4) comprises external threaded part for receiving a diffuser insert and the diffuser insert (9k') comprises an internal threaded part.

According to another embodiment of the invention, the spatial distribution of the diffuser inserts varies along the longitudinal axis of said diffuser (4). For instance, the nozzles are implemented with a density varying as a function of the expected local diffusion flow: the higher density of apertures corresponds to the higher diffusion flow. According to a particular embodiment, end-capped diffuser inserts can be used to modify the pitch between adjacent open channel diffuser inserts.

According to an aspect of the invention, the diffuser is a mechanical part separate from the injector, with a predetermined spatial distribution of diffusion inserts. Preferably, the injector is made of chromium-plated or electro-polished stainless steel. Diffuser inserts are made of a material suitable for sustaining corrosion from high temperature vaporized materials. Preferably, diffuser inserts are made of graphite or ceramics.

Another aspect of the invention concerns a calibration process of an injector. In a first step, the diffuser is arranged following an initial configuration, for instance with identical nozzles or diffuser inserts with a constant pitch. The deposition of vaporized materials on a substrate is performed using this diffuser initial configuration. Then, a uniformity profile of said deposited materials is measured. Depending on the measured non uniformity, one or several diffuser inserts are replaced with other nozzles / diffuser inserts or end-capped diffuser inserts. If necessary, the deposition and measurements steps are repeated until satisfying uniformity is obtained. For instance, a numerical value defining the maximum non-uniformity can be used to determine operating conditions. The non-uniformity criterion can be used to control repeatability of deposition conditions over time and to determine when diffuser insert(s) need to be replaced.

Still another aspect of the invention concerns a process for manufacturing a diffuser. In a first step, the diffusion profile of a diffuser insert is modelled using diffusion flow models. In a second step, the diffusion profile of a set of a plurality of inserts is corrected as a function of the respective positions of each insert along the longitudinal axis of said diffuser. In another step, the desired diffusion profile is compared with the modelled diffusion profile of the set of diffuser inserts.

The invention applies to the deposition process of selenium layers for thin films CIGS solar cells. The injector can be used for deposition of other chemical elements or materials, in particular such as cadmium, tellurium, zinc, phosphor or magnesium.

## Advantages

The invention enables to improve uniformity of deposited materials along the longitudinal axis of the injector (3).

Using the invention, a same deposition machine can be used for different types of applications or for different substrates with varying dimensions. Depending on the applications, the diffuser and/or diffuser inserts can be replaced in order to optimize nozzle output aperture number, positions and/or throughput. Exchanging diffuser inserts is quick thus downtime of the vacuum deposition machine is kept to a minimum.

The invention enables improving the repeatability in uniformity of material deposited by a vacuum vapour deposition machine over time.

## Claims

1. Injector (3) for a vacuum vapour deposition system, said injector comprising :

   • an injection duct suitable for receiving vaporized materials from a vacuum evaporation source (2), and
   • a diffuser (4) comprising a plurality of nozzles for diffusing said vaporized materials into a vacuum deposition chamber (5), each nozzle comprising a channel (13) suitable for connecting said injection duct to said deposition chamber (5),

   **characterised in that** said diffuser (4) has a spatially varying nozzle distribution wherein at least one of said nozzles comprises at least one removable diffuser insert (9), said diffuser (4) comprising diffuser insert receiving means and said removable diffuser insert (9) comprising attachment means (15) suitable for being fitted to said receiving means, and wherein at least one removable diffuser insert (9c) is suitable for obturating a nozzle.

2. Injector (3) according to claim 1, **characterized in that** said diffuser comprises at least two nozzles having different channel geometries.

3. Injector (3) according to claim 1 or 2, **characterized in that** said diffuser comprises at least three nozzles aligned along a longitudinal axis and having different spacings between two adjacent nozzles.

4. Injector (3) according to claim 1, **characterized in that** said diffuser insert (9) comprises at least an input aperture (11, 11 a, 11 b, 11c) at one end of said channel (13) emerging inside said injection duct and at least an output aperture (12) at another end of said channel (13) emerging outside said injection duct.

5. Injector (3) according to any of claims 1 to 4, **characterized in that** said diffuser (3) receiving means comprise an internal thread and **in that** said diffuser insert (9) attachment means comprise an external thread (15) fitted to said diffuser internal thread.

6. Injector (3) according to any of claims 1 to 5, **characterized in that** said diffuser (3) receiving means comprise an external thread and **in that** said diffuser insert (9) attachment means comprise an internal thread fitted to said diffuser external thread.

7. Vacuum deposition system comprising a vacuum evaporation source an injector according to any one of claims 1 to 6 and a vacuum deposition chamber.

8. Process for calibrating an injector according to any of claims 1 to 6, comprising the following steps :

   a) arrangement of a diffuser comprising a plurality of nozzles distributed along a longitudinal axis following an initial configuration wherein at least one of said nozzles comprises at least one removable diffuser insert and wherein at least one removable diffuser insert (9c) is suitable for obturating a nozzle ;

b) deposition of vaporized materials on a substrate using said diffuser in said initial configuration ;

c) measurement of a uniformity profile of said deposited materials ;

d) modification of the spatial distribution of said nozzles as a function of said measured uniformity profile, in order to reduce non-uniformity of deposited materials.

9.  Process according to claim 8 which comprises repeated implementation of steps (b) to (d).

10. Process according to claim 8 or claim 9 wherein modification of the spatial distribution of said nozzles comprises a replacement of the removable diffuser insert by another removable diffuser insert.

11. Process for manufacturing a diffuser for an injector for a vacuum deposition system according to any of claims 1 to 6, comprising the following steps:

e) Manufacturing of an injector for a vacuum deposition system, said injector comprising a diffuser comprising at least a plurality of diffuser insert receiving means aligned along a longitudinal axis,

f) Manufacturing of a removable diffuser insert comprising attachment means suitable for being fitted to said receiving means of said diffuser, wherein at least one removable diffuser insert (9c) is suitable for obturating a nozzle,

g) Assembling said removable diffuser insert with said diffuser.

12. Process for manufacturing a diffuser for an injector for a vacuum deposition system, said process comprising the following steps :

(h) Providing an injector comprising a diffuser comprising an injection duct and at least a plurality of diffuser insert receiving means aligned along a longitudinal axis;

(i) Modelling the diffusion profile of a diffuser insert using diffusion flow models;

(j) Correcting the diffusion profile of a set of a plurality of inserts as a function of the respective positions of each insert along the longitudinal axis of said diffuser;

(k) Comparing the desired diffusion profile with the modelled diffusion profile of the set of diffuser inserts;

(l) Defining the diffuser insert distribution corresponding to the desired diffusion profile;

(m)Inserting diffuser inserts comprising attachment means suitable for being fitted to said receiving means of said diffuser into the corresponding receiving means, wherein at least one removable diffuser insert (9c) is suitable for obturating a nozzle.

**Patentansprüche**

1.  Injektor (3) für ein Vakuumdampfabscheidungssystem, wobei der Injektor umfasst:

    • eine Einspritzleitung, die geeignet ist, verdampfte Materialien aus einer Vakuumverdampfungsquelle (2) aufzunehmen, und
    • einen Diffusor (4), der mehrere Düsen umfasst, um die verdampften Materialien in eine Vakuumabscheidungskammer (5) zu diffundieren, wobei jede Düse einen Kanal (13) umfasst, der geeignet ist, die Einspritzleitung mit der Abscheidungskammer (5) zu verbinden,

    **dadurch gekennzeichnet, dass** der Diffusor (4) eine räumlich variierende Düsenverteilung aufweist, wobei mindestens eine der Düsen mindestens einen entfernbaren Diffusoreinsatz (9) umfasst, wobei der Diffusor (4) Aufnahmemittel für einen Diffusoreinsatz umfasst, und wobei der entfernbare Diffusoreinsatz (9) Befestigungsmittel (15) umfasst, die geeignet sind, mit den Aufnahmemitteln zusammenzupassen, und wobei mindestens ein entfernbarer Diffusoreinsatz (9c) dafür geeignet ist, eine Düse abzudichten.

2.  Injektor (3) nach Anspruch 1, **dadurch gekennzeichnet, dass** der Diffusor mindestens zwei Düsen umfasst, die unterschiedliche Kanalgeometrien aufweisen.

3.  Injektor (3) nach Anspruch 1 oder 2, **dadurch gekennzeichnet, dass** der Diffusor mindestens drei Düsen umfasst, die entlang einer Längsachse ausgerichtet sind und die unterschiedliche Abstände zwischen zwei benachbarten Düsen aufweisen.

4.  Injektor (3) nach Anspruch 1, **dadurch gekennzeichnet, dass** der Diffusoreinsatz (9) mindestens eine Eingangsöffnung (11, 11a, 1b, 11c) an einem Ende des Kanals (13), bei dem die Einspritzleitung innen auftritt, und mindestens eine Ausgangsöffnung (12) an einem anderen Ende des Kanals (13), bei dem die Einspritzfeitung außen auftritt, umfasst.

5.  Injektor (3) nach einem der Ansprüche 1 bis 4, **dadurch gekennzeichnet, dass** die Aufnahmeelemente des Diffusors (4) ein Innengewinde umfassen und dass die Befestigungsmittel des Diffusoreinsatzes (9) ein Außengewinde (15) umfassen, das mit dem Innengewinde des Diffusors zusammenpasst.

6.  Injektor (3) nach einem der Ansprüche 1 bis 5, **da-**

**durch gekennzeichnet, dass** die Aufnahmeelemente des Diffusors (4) ein Außengewinde umfassen und dass die Befestigungsmittel des Diffusoreinsatzes (9) ein Innengewinde umfassen, das mit dem Außengewinde des Diffusors zusammenpasst.

7. Vakuumabscheidungssystem, das eine Vakuumverdampfungsquelle, einen Injektor nach einem der Ansprüche 1 bis 6 und eine Vakuumabscheidungskammer umfasst.

8. Verfahren zum Kalibrieren eines Injektors nach einem der Ansprüche 1 bis 6, das die folgenden Schritte umfasst:

a) Anordnung eines Diffusors, der mehrere Düsen umfasst, die entlang einer Längsachse, die einer Anfangskonfiguration folgt, verteilt sind, wobei mindestens eine der Düsen mindestens einen entfernbaren Diffusoreinsatz umfasst und wobei mindestens ein entfernbarer Diffusoreinsatz (9c) dafür geeignet ist, eine Düse abzudichten;
b) Abscheidung von verdampften Materialien auf einem Substrat unter Verwendung des Diffusors in der Anfangskonfiguration;
c) Messung eines Gleichmäßigkeitsprofils der abgeschiedenen Materialien;
d) Modifizierung der räumlichen Verteilung der Düsen als eine Funktion des gemessenen Gleichmäßigkeitsprofils, um eine Nicht-Gleichmäßigkeit der abgeschiedenen Materialien zu vermindern.

9. Verfahren nach Anspruch 8, das eine wiederholte Implementierung der Schritte (b) bis (d) umfasst.

10. Verfahren nach Anspruch 8 oder 9, wobei eine Modifizierung der räumlichen Verteilung der Düsen einen Austausch des entfernbaren Diffusoreinsatzes durch einen anderen entfernbaren Diffusoreinsatz umfasst.

11. Verfahren zum Herstellen eines Diffusors für einen Injektor für ein Vakuumabscheidungssystem nach einem der Ansprüche 1 bis 6, das die folgenden Schritte umfasst:

e) Herstellen eines Injektors für ein Vakuumabscheidungssystem, wobei der Injektor einen Diffusor umfasst, der mindestens mehrere Aufnahmemittel für einen Diffusoreinsatz, die entlang einer Längsachse ausgerichtet sind, umfasst,
f) Herstellen eines entfernbaren Diffusoreinsatzes, der Befestigungsmittel umfasst, die geeignet sind, mit den Aufnahmeelementen des Diffusors zusammenzupassen, wobei mindestens ein entfernbarer Diffusoreinsatz (9c) dafür geeignet ist, eine Düse abzudichten.
g) Zusammenbauen des entfernbaren Diffusoreinsatzes mit dem Diffusor.

12. Verfahren zum Herstellen eines Diffusors für einen Injektor für ein Vakuumabscheidungssystem, wobei das Verfahren die folgenden Schritte umfasst:

h) Bereitstellen eines Injektors, der einen Diffusor umfasst, der eine Einspritzleitung und mindestens mehrere Aufnahmemittel für einen Diffusoreinsatz, die entlang einer Längsachse ausgerichtet sind, umfasst;
i) Modellieren des Diffusionsprofils eines Diffusoreinsatzes unter Verwendung der Diffusionsströmungsmodelle;
j) Korrigieren des Diffusionsprofils eines Satzes von mehreren Einsätzen als eine Funktion der jeweiligen Positionen jedes Einsatzes entlang der Längsachse des Diffusors;
k) Vergleichen des gewünschten Diffusionsprofils mit dem modellierten Diffusionsprofil des Satzes von Diffusoreinsätzen:
l) Definieren der Diffusoreinsatzverteilung entsprechend des gewünschten Diffusionsprofils;
m) Einsetzen der Diffusoreinsätze, die Befestigungsmittel umfassen, die geeignet sind, mit den Aufnahmeelementen des Diffusors in den entsprechenden Aufnahmeelementen zusammenzupassen, wobei mindestens ein entfernbarer Diffusoreinsatz (9c) dafür geeignet ist, eine Düse abzudichten.

**Revendications**

1. Injecteur (3) pour un système de dépôt sous vide en phase vapeur, ledit injecteur comprenant :

• une conduite d'injection appropriée pour recevoir des matériaux vaporisés à partir d'une source d'évaporation sous vide (2), et
• un diffuseur (4) comprenant une pluralité de buses pour la diffusion desdits matériaux vaporisés dans une chambre de dépôt sous vide (5), chaque buse comprenant un canal (13) approprié pour la connexion de ladite conduite d'injection à ladite chambre de dépôt (5),

**caractérisé en ce que** ledit diffuseur (4) a une répartition de buses variant spatialement, où au moins une desdites buses comprend au moins un insert de diffuseur amovible (9), ledit diffuseur (4) comprenant des moyens de réception d'insert de diffuseur et ledit insert de diffuseur amovible (9) comprenant des moyens d'attache (15) appropriés pour être fixés sur lesdits moyens de réception, et où au moins un insert de diffuseur amovible (9c) est approprié pour obturer une buse.

2. Injecteur (3) selon la revendication 1, **caractérisé en ce que** ledit diffuseur comprend au moins deux buses ayant des géométries de canal différentes.

3. Injecteur (3) selon la revendication 1 ou 2, **caractérisé en ce que** ledit diffuseur comprend au moins trois buses alignées le long d'un axe longitudinal et ayant des espacements différents entre deux buses adjacentes.

4. Injecteur (3) selon la revendication 1, **caractérisé en ce que** ledit insert de diffuseur (9) comprend au moins une ouverture d'entrée (11, 11a, 11b, 11c) à une extrémité dudit canal (13), émergeant à l'intérieur de ladite conduite d'injection, et au moins une ouverture de sortie (12) à une autre extrémité dudit canal (13), émergeant à l'extérieur de ladite conduite d'injection.

5. Injecteur (3) selon l'une quelconque des revendications 1 à 4, **caractérisé en ce que** lesdits moyens de réception de diffuseur (3) comprennent un filetage interne et **en ce que** lesdits moyens d'attache d'insert de diffuseur (9) comprennent un filetage externe (15) ajusté audit filetage interne du diffuseur.

6. Injecteur (3) selon l'une quelconque des revendications 1 à 5, **caractérisé en ce que** lesdits moyens de réception du diffuseur comprennent un filetage externe et **en ce que** lesdits moyens d'attache d'insert de diffuseur (9) comprennent un filetage interne ajusté audit filetage externe du diffuseur.

7. Système de dépôt sous vide comprenant une source d'évaporation sous vide, un injecteur selon l'une quelconque des revendications 1 à 6, et une chambre de dépôt sous vide.

8. Procédé d'étalonnage d'un injecteur selon l'une quelconque des revendications 1 à 6, comprenant les étapes suivantes :

a) aménagement d'un diffuseur comprenant une pluralité de buses réparties le long d'un axe longitudinal suivant une configuration initiale, où au moins une desdites buses comprend au moins un insert de diffuseur amovible et où au moins un insert de diffuseur amovible (9c) est approprié pour obturer une buse ;
b) dépôt de matériaux vaporisés sur un substrat à l'aide dudit diffuseur dans ladite configuration initiale ;
c) mesure d'un profil d'uniformité desdits matériaux déposés ;
d) modification de la répartition spatiale desdites buses en fonction dudit profil d'uniformité mesuré, afin de réduire la non-uniformité des matériaux déposés.

9. Procédé selon la revendication 8, qui comprend la mise en oeuvre répétée des étapes (b) à (d).

10. Procédé selon la revendication 8 ou la revendication 9, dans lequel la modification de la répartition spatiale desdites buses comprend un remplacement de l'insert de diffuseur amovible par un autre insert de diffuseur amovible.

11. Procédé de fabrication d'un diffuseur pour un injecteur pour un système de dépôt sous vide selon l'une quelconque des revendications 1 à 6, comprenant les étapes suivantes :

e) fabrication d'un injecteur pour un système de dépôt sous vide, ledit injecteur comprenant un diffuseur comprenant au moins une pluralité de moyens de réception d'insert de diffuseur alignés le long d'un axe longitudinal ;
î) fabrication d'un insert de diffuseur amovible comprenant des moyens d'attache appropriés pour être fixés sur lesdits moyens de réception dudit diffuseur, où au moins un insert de diffuseur amovible (9c) est approprié pour obturer une buse ;
g) assembler ledit insert de diffuseur amovible audit diffuseur.

12. Procédé de fabrication d'un diffuseur pour un injecteur pour un système de dépôt sous vide, ledit procédé comprenant les étapes suivantes :

h) prévoir un injecteur comprenant un diffuseur comprenant une conduite d'injection et au moins une pluralité de moyens de réception d'insert de diffuseur alignés le long d'un axe longitudinal ;
i) modélisation du profil de diffusion d'un insert de diffuseur à l'aide de modèles d'écoulement de diffusion ;
j) correction du profil de diffusion d'un ensemble d'une pluralité d'inserts en fonction des positions respectives de chaque insert le long de l'axe longitudinal dudit diffuseur ;
k) comparaison du profil de diffusion souhaité au profil de diffusion modélisé de l'ensemble d'inserts de diffuseur ;
l) définition de la répartition d'inserts de diffuseur correspondant au profil de diffusion souhaité ;
m) insertion des inserts de diffuseurs comprenant des moyens d'attache appropriés pour être fixés sur lesdits moyens de réception dudit diffuseur dans les moyens de réception correspondants, où au moins un insert de diffuseur amovible (9c) est approprié pour obturer une buse.

Figure 1

Figure 2

## Figure 3

## Figure 4

Figure 5

Figure 6

Figure 7

Figure 8

Figure 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100248416 A